# EUROPEAN PATENT APPLICATION

(11) **EP 0 800 267 A2**
(43) Date of publication of application: **08.10.1997**
(21) Application number: 97301930.0
(22) Date of filing: 21.03.1997
(51) Int. Cl.: H03G 3/20

(54) **Apparatus for envelope shaping of burst signals in a transmitter**

(30) Priority: 04.04.1996 JP 82359/96
(71) Applicant: MATSUSHITA ELECTRIC INDUSTRIAL CO., LTD., Kadoma-shi Osaka (JP)
(72) Inventor: Hiramatsu, Katsuhiko, Yokohama-shi (JP)
(74) Representative: Smith, Norman Ian

(57) **Abstract**

A transmission apparatus using the modulation system in which an envelope is reduced to zero at a moment on the way of transmission includes a mapping circuit (1) for mapping a transmission signal in the signal point arrangement, D/A converters (2, 3) for converting signals for I and Q channels obtained by the mapping circuit into respective analog signals, switches (4, 5) for turning on and off the respective converted analog signals in accordance with a transmission on/off control signal, and band restriction filters (6, 7) for band-restricting the on-and-off controlled analog signals. Variation of the envelope is increased on the way of transmission as compared with just after the beginning of transmission and accordingly by suppressing leakage power between adjacent channels during transmission by the filters (6, 7), the ramp process can be performed practically in accordance with on and off control of transmission by the switches (4, 5).

## Description

### BACKGROUND OF THE INVENTION

### Field of the Invention

The present invention relates to a transmission apparatus for performing the ramp process for removing steep on and off of a transmission signal in a burst time.

### Description of the Related Art

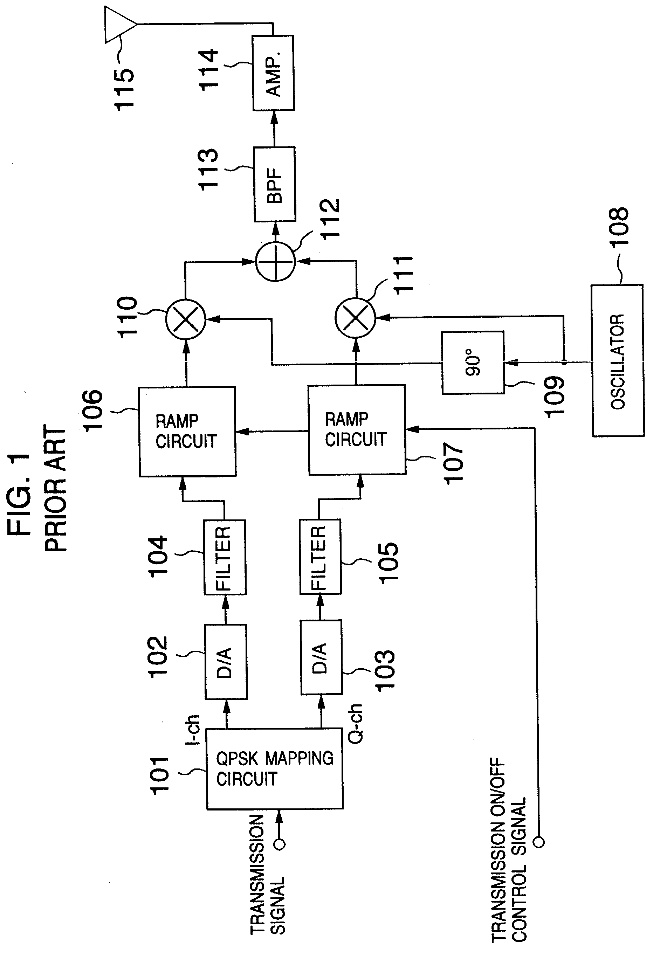

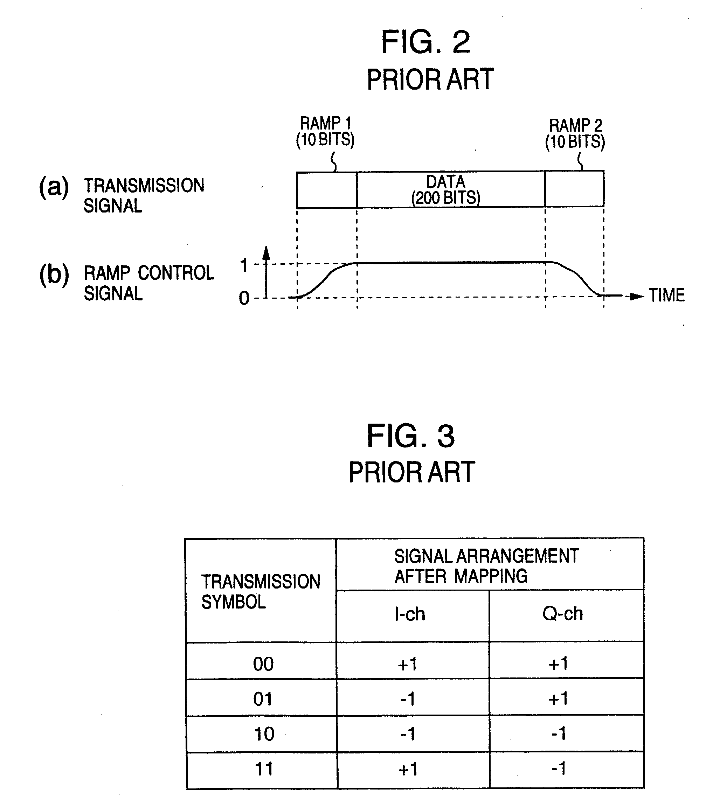

Fig. 1 schematically illustrates a conventional transmission apparatus of this kind using the QPSK (quadrature phase shift keying) modulation as a modulation method and Fig. 2 shows a frame format, a ramping timing and a ramping waveform of a transmission signal of the transmission apparatus of Fig. 1. In Fig. 1, numeral 101 denotes a QPSK mapping circuit, 102 and 103 D/A (digital-to-analog) converters, 104 and 105 band restriction filters, 106 and 107 ramp circuits, 108 an oscillator, 109 a 90-degree phase shifter, 110 and 111 multipliers, 112 an adder, 113 a band pass filter (BPF), 114 an amplifier and 115 an antenna.

Operation of the conventional transmission apparatus is now explained. Transmission data is first inputted to the QPSK mapping circuit 101 to be mapped in the signal point arrangement of the QPSK. Actually, signals are arranged as shown in Fig. 3. Signals for the I channel and Q channel obtained by the arrangement are converted into analog signals by the D/A converters 102 and 103. The respective analog signals converted by the D/A converters are band-restricted by the band restriction filters 104 and 105 and are subjected to the rising process and the falling process of the burst signal in the ramp circuits 106 and 107. Control of the rising and falling process is performed by a transmission on/off control signal from the transmission apparatus. The signals subjected to the rising and falling process are further subjected to the quadrature modulation by means of the oscillator 108, the 90-degree phase shifter 109, the multipliers 110 and 111, the adder 112 and the band pass filter 113 and the quadrature modulated signal is amplified by the amplifier 114 to be transmitted from the antenna 115.

Next, the ramp process is now explained. The transmission signal having the frame format shown in Fig. 2(a) includes ramp bits for ramps 1 and 2 positioned before and after data. One burst includes the ramp 1 (10 bits), the ramp 2 (10 bits) and the data (200 bits). Fig. 2(b) shows a ramp control signal. The ramp circuits 106 and 107 gradually increase a signal level of the transmission signal during the period of the ramp 1, transmit the transmission signal at 100% level during the transmission time of the data and gradually reduce the signal level of the transmission signal during the period of the ramp 2 in accordance with the timing shown in Fig. 2(b). By performing such a ramp process, there is a merit that the signal can be prevented from being turned on and off steeply during the burst period and a frequency component other than the transmission band is not increased.

However, the conventional transmission apparatus described above requires the ramp circuit for producing a ramp waveform for gradually turning on and off the transmission signal, so that the circuit scale is increased. Further, when the ramp process is performed by means of the analog signal process, the high accuracy waveform control is impossible due to secular change and temperature change.

On the other hand, JP-A-6-296183, JP-A-7-58784 and JP-A-7-202960 describe the digital signal process for performing the ramp process. These references describe that a signal waveform is expressed by 8 bit-data, for example, and the data is bit-shifted to thereby produce a ramp waveform. However, such a method also increases the circuit scale.

### SUMMARY OF THE INVENTION

It is an object of the present invention to solve the above problems in the prior art by providing a transmission apparatus capable of performing the ramp process easily.

In the case where a modulation system, in which a signal level is reduced to zero at a moment during transmission, such as QPSK (Quadrature Phase Shift Keying), 16PSK (16 Phase Shift Keying) or 16APSK (16 Amplitude Phase Shift Keying) or a differentially coded modulation system of the above modulation systems or 16QAM (Quadrature Amplitude Modulation), 32QAM, 64QAM, 256QAM or the like is used, in order to achieve the above object, the present invention is aimed to control turning on and off of a transmission signal before or after D/A conversion at the timing of controlling on and off of transmission so that the transmission signal is band-restricted to realize the ramp process by means of a simplified circuit.

The transmission apparatus according to a first aspect of the present invention comprises a mapping circuit for mapping the transmission data into one of predetermined signal points in the orthogonal coordinates to produce a data signal of a first channel corresponding to one coordinate axis in the orthogonal coordinates and a data signal of a second channel corresponding to the other coordinate axis, digital-to-analog converters for converting the data signals of the first and second channels produced by said mapping circuit into respective analog signals, switch means for turning on and off the respective analog signals converted by said digital-to-analog converters in accordance with a control signal which controls on and off of transmission of said transmission apparatus, and filter means for band-restricting output signals of said switch means.

The transmission apparatus according to a second aspect of the present invention comprises a mapping circuit for mapping the transmission data into one of predetermined signal points in the orthogonal coordinates to produce a data signal of a first channel corresponding to one coordinate axis in the orthogonal coordinates and a data signal of a second channel corresponding to the other coordinate axis, a ramp circuit for receiving the data signals of the first and second channels produced by said mapping circuit to output selected one of the data signal of the first channel and a predetermined potential and output selected one of the data signal of the second channel and the predetermined potential in accordance with a control signal which controls on and off of transmission of said transmission apparatus, digital-to-analog converters for converting the data signals of the first and second channels produced by said ramp circuit into respective analog signals, and filter means for band-restricting the respective analog signals converted by said digital-to-analog converters.

### BRIEF DESCRIPTION OF THE DRAWINGS

Fig. 1 is a block diagram schematically illustrating a conventional transmission apparatus;
Fig. 2 shows a frame format and a transmission timing in the prior art;
Fig. 3 shows mapping of the signal point arrangement in the QPSK;
Fig. 4 is a block diagram schematically illustrating a transmission apparatus according to a first embodiment of the present invention;
Fig. 5 shows a frame format and a transmission timing in the first embodiment of the present invention;
Fig. 6A is a waveform transition diagram during transmission in the first embodiment of the present invention;
Fig. 6B is a waveform transition diagram just after the beginning of transmission in the first embodiment of the present invention;
Fig. 7 shows comparison of leakage power between adjacent channels;
Fig. 8 is a block diagram schematically illustrating a transmission apparatus according to a second embodiment of the present invention;
Fig. 9 is a block diagram of a ramp circuit and a D/A converter in the second embodiment of the present invention; and
Fig. 10 shows a truth table of a 2-bit D/A converter in the second embodiment of the present invention.

### DESCRIPTION OF THE PREFERRED EMBODIMENTS

### (FIRST EMBODIMENT)

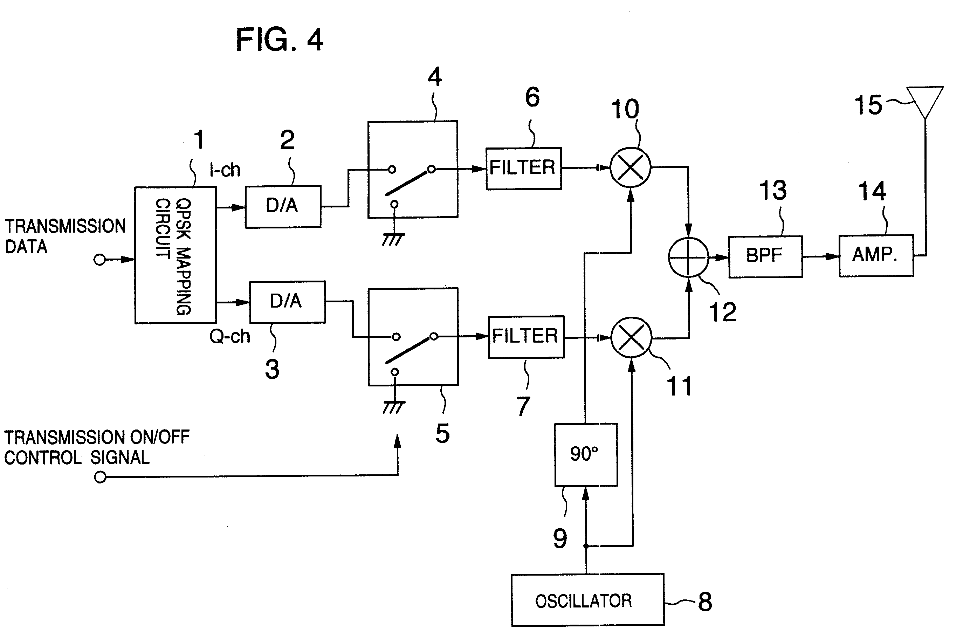

An embodiment of the present invention is now described with reference to the accompanying drawings. Fig. 4 schematically illustrating a transmission apparatus according to the first embodiment of the present invention. In Fig. 4, numeral 1 denotes a QPSK mapping circuit, 2 and 3 D/A converters, 4 and 5 switches, 6 and 7 band restriction filters, 8 an oscillator, 9 a 90-degree phase shifter, 10 and 11 multipliers, 12 an adder, 13 a band pass filter (BPF), 14 an amplifier and 15 an antenna.

Operation of the first embodiment is now explained. Transmission data is first inputted to the QPSK mapping circuit 1 and is mapped in the signal point arrangement of the QPSK. Actually, signals are arranged as shown in Fig. 3. Signals for the I channel and Q channel obtained by the arrangement are converted into analog signals by the D/A converters 2 and 3. The respective analog signals converted by the D/A converters are turned on and off by the switches 4 and 5 in accordance with a transmission on/off control signal and are band-restricted by the band restriction filters 6 and 7. The signals from the filters are subjected to the quadrature modulation by means of the oscillator 8, the 90-degree phase shifter 9, the multipliers 10 and 11, the adder 12 and the band pass filter 13 and the signal subjected to the quadrature modulation is amplified by the amplifier 14 to be transmitted from the antenna 15.

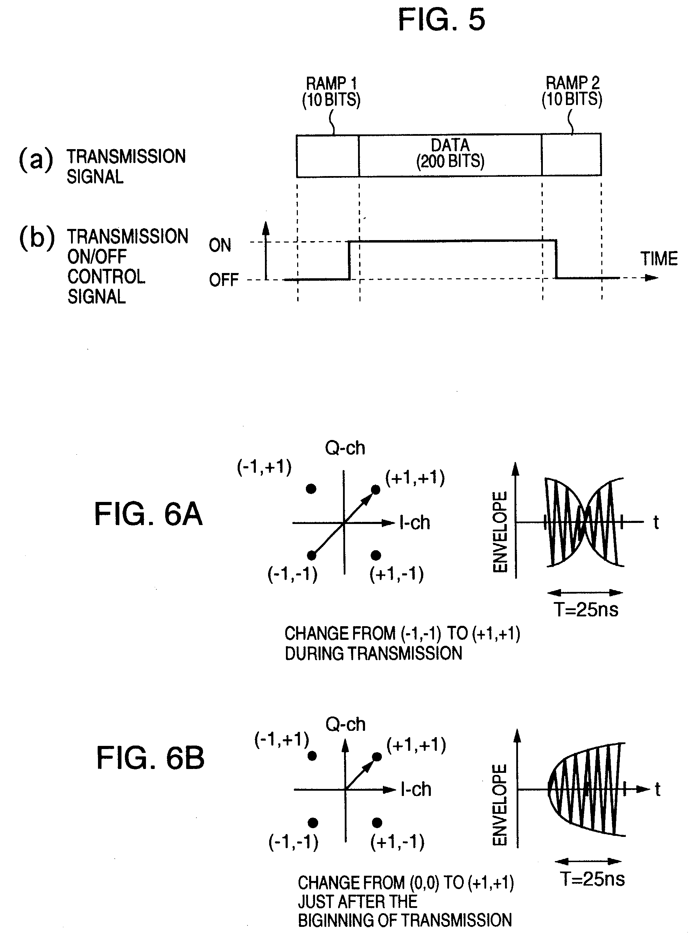

Next, the ramp process is now explained. Fig. 5(a) shows a frame format of a transmission signal including ramp bits composed of ramps 1 and 2 positioned before and after data. One burst includes the ramp 1 (10 bits), the ramp 2 (10 bits) and the data (200 bits). Fig. 5(b) shows a transmission on/off control signal for controlling the ramp. The switches 4 and 5 are turned on in the period of the ramp 1 and is turned off in the period of the ramp 2.

The reason why a frequency component other than the transmission band is not increased by means of the above ramp process is now explained with reference to Figs. 6A and 6B. In the modulation system such as the QPSK modulation, an envelope becomes zero at a moment not only upon a transient response but also on the way of transmission. Since the transmission symbol signals are band-restricted by the band restriction filters 6 and 7 at the later stage, the band restriction is ensured even in the pattern in which the envelope is once reduced to zero so that the transmission symbol transfers by 180 degrees. Similarly, the band restriction is also ensured even upon the beginning of transmission where the envelope starts to be increased from zero and even upon the end of the transmission where the envelope is reduced to zero. For example, as shown in Fig. 6A, when transition is made from (-1, -1) to (+1, +1), the amplitude of the envelope is once reduced from 2^{1/2} to zero and then returned to 2^{1/2}. As compared with upon the beginning of transmission (Fig. 6B) where the amplitude of the envelope is increased from zero to 2^{1/2} in the time period of T (T represents one symbol period) upon the beginning of transmission, when transition is made from (-1, -1) to (+1, +1), the amplitude of the envelope curve is reduced from 2^{1/2} to zero in the time period of T/2 and increased from zero to 2^{1/2} in the time period of T/2. In this manner, variation of the envelope is larger on the way of transmission than immediately after the beginning of transmission and accordingly by suppressing leakage power between adjacent channels during transmission by using the filters 6 and 7, the practical ramp process can be performed by on and off control of transmission by means of the switches 4 and 5.

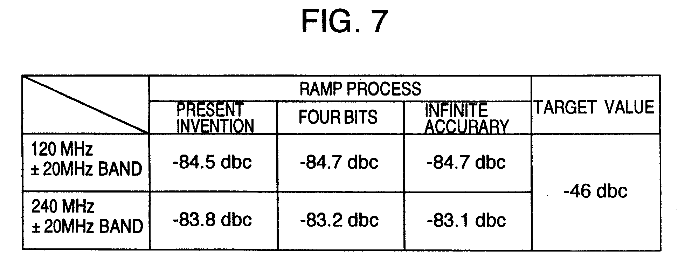

Fig. 7 shows comparison of a ratio (dBc) of leakage power to the adjacent channel versus carrier power in the case of the present invention and the case where the ramp process with four bits (seven values) or infinite accuracy is performed in the QPSK modulation system. It is understood that a difference of leakage power to the adjacent channel between the case of the present invention and the case where the ramp process with the infinite accuracy is performed is as very small as 0.7 dB at the maximum. In the above comparison, the ramp process has been performed by approximating the Hunning window for 10 symbols of the ramp. In the case of four bits accuracy, the Hunning window is approximated by seven values, and in the case of the infinite accuracy, the Hunning window is approximated by the infinite accuracy.

As described above, according to the first embodiment, in the modulation system in which the envelope of signal is reduced to zero on the way of transmission, the ramp process can be easily realized by the on and off control of transmission by the switches and the filtering process.

In the embodiment, although the QPSK modulation system is used, the modulation system of 8PSK, 16PSK, 16APSK, 32APSK, 16QAM, 32QAM, 64QAM and 256QAM, in which only the number of bits in serial-to-parallel conversion and the mapping method for I and Q channels are different, can be used to realize the present invention by the same configuration of the transmission apparatus.

### (SECOND EMBODIMENT)

The second embodiment of the present invention is now described. In the first embodiment, the ramp process of the transmission apparatus is performed by using the analog switches, while in the second embodiment the transmission on/off control signal is supplied to the ramp circuit to which I and Q channel signals are supplied, to control digital data so that outputs of D/A converters connected to a ramp circuit are controlled to be reduced to zero except the transmission time.

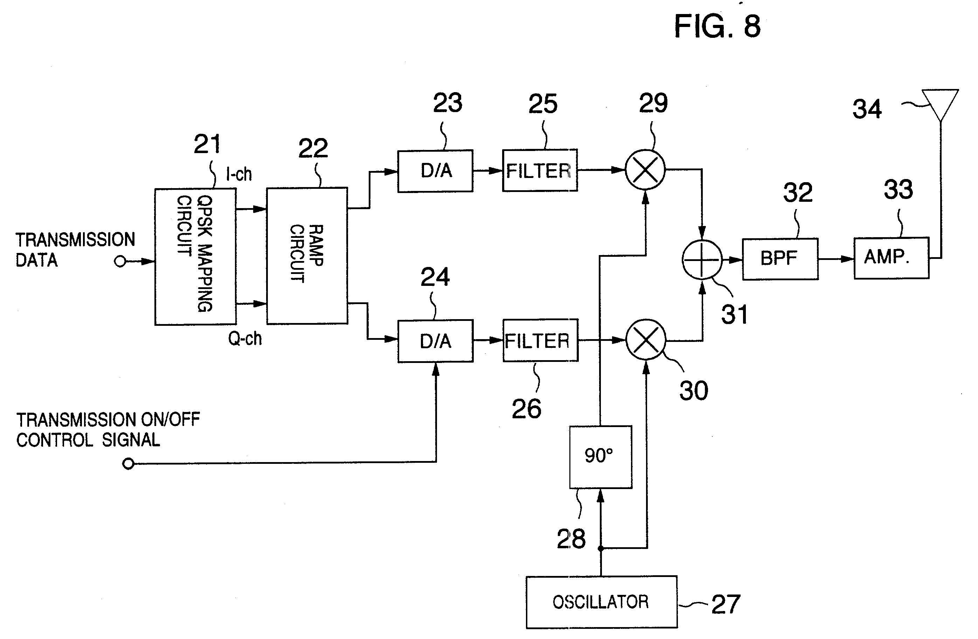

Fig 8 schematically illustrates a transmission apparatus according to the second embodiment of the present invention. In Fig. 8, numeral 21 denotes a QPSK mapping circuit, 22 a ramp circuit, 23 and 24 D/A converters, 25 and 26 band restriction filters, 27 an oscillator, 28 a 90-degree phase shifter, 29 and 39 multipliers, 31 an adder, 32 a band pass filter (BPF), 33 an amplifier and 34 an antenna.

Operation of the second embodiment is now described. Transmission data is first inputted to the QPSK mapping circuit 21 and is mapped in the signal point arrangement of the QPSK. Actually, signals are arranged as shown in Fig. 3. Signals for the I channel and Q channel obtained by the arrangement are inputted to the ramp circuit 22 and turned on and off by the transmission on/off control signal. The on and off controlled signals are converted into analog signals by the D/A converters 23 and 24 and are band-restricted by the band restriction filters 25 and 26, respectively. The band-restricted signals are subjected to the quadrature modulation by means of the oscillator 27, the 90-degree phase shifter 28, the multipliers 29 and 30, the adder 31 and the band pass filter 32 and the signals subjected to the quadrature modulation is amplified by the amplifier 33 to be transmitted from the antenna 34.

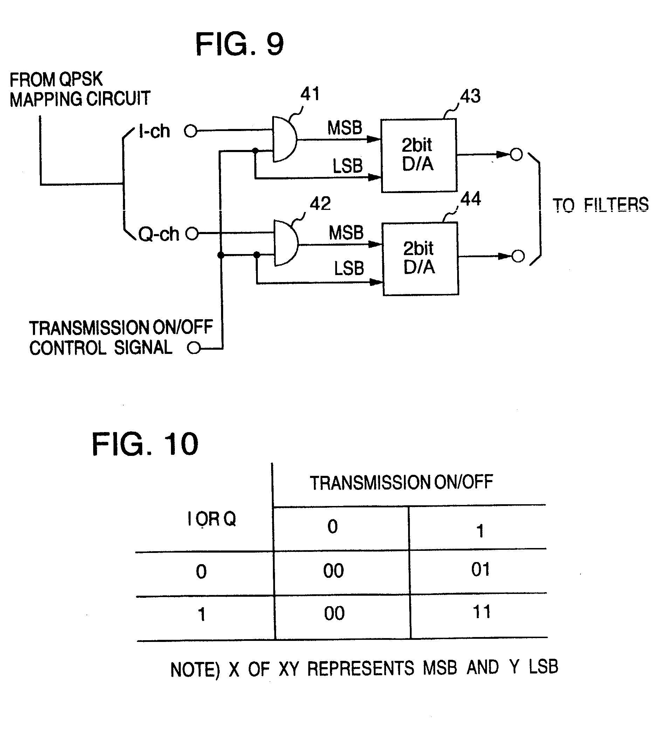

Next, the ramp process is now explained. Fig. 9 schematically illustrates a practical example of the ramp circuit 22 and the D/A converters 23 and 24. In Fig. 9, numerals 41 and 42 denote AND circuits, and 43 and 44 2-bit D/A converters. In the embodiment, since analog values of ±1 and 0 must be outputted, the D/A converters 43 and 44 of two bits are used. Fig. 10 shows a truth table of the 2-bit D/A converter.

In Fig. 10, data X of 2-bit data XY represents the most significant bit (MSB) in Fig. 9 and data Y represents the least significant bit (LSB) in Fig. 9. The 2-bit D/A converter produces an analog value of 0 for the value of XY of "00", an analog value of +1 for "01", and analog value of -1 for "11".

The case where the transmission on/off control signal is "0" is now explained. Even when the input data I or Q is any of "0" and "1", the ramp circuit supplies "00" to the 2-bit D/A converters which in turn output an analog value of 0. This corresponds to the origin of Fig. 6B.

The case where the transmission on/off control signal is "1" is now explained. When the input data I or Q is "0", the ramp circuit supplies "01" to the 2-bit D/A converters which in turn output an analog value of +1. On the other hand, when the input data I or Q is "1", the ramp circuit supplies "11" to the 2-bit D/A converters which in turn output an analog value of -1. That is, when the value of (I, Q) is (0, 0), the output of the 2-bit D/A converters 43, 44 corresponds to (+1, +1) of Fig. 6B. Similarly, (0, 1) corresponds to (+1, -1), (1, 0) corresponds to (-1, +1) and (1, 1) corresponds to (-1, -1). In this manner, the 2-bit D/A converters produce the analog value corresponding to the value of (I, Q) upon transmission and reduce the amplitude of the analog value to zero upon stop of transmission.

As described above, according to the second embodiment, the transmission on/off control signal is supplied to the ramp circuit, to which the I and Q channel signals are supplied, so that the output of the D/A converters are controlled to be reduced to zero except for the transmission time to thereby realize the ramp process simply. Further, the ramp circuit can be realized by a simple configuration of two AND circuits and it is sufficient for the D/A converter to operate with two-bit accuracy.

In the embodiment, although the QPSK modulation system is used, the modulation system of 8PSK, 16PSK, 16APSK, 32APSK, 16QAM, 32QAM, 64QAM and 256QAM, in which only the number of bits in serial-to-parallel conversion and the mapping method to I and Q channels are different, can be used to realize the present invention by the same configuration of the transmission apparatus.

## Claims

1. A transmission apparatus for modulating a carrier signal by transmission data and transmitting the modulated carrier signal having an envelope an amplitude of which is reduced to substantially zero in accordance with predetermined change of the transmission data, said apparatus comprising:
a mapping circuit (1) for mapping the transmission data into one of predetermined signal points in the orthogonal coordinates to produce a data signal of a first channel corresponding to one coordinate axis in the orthogonal coordinates and a data signal of a second channel corresponding to the other coordinate axis;
digital-to-analog converters (2, 3) for converting the data signals of the first and second channels produced by said mapping circuit (1) into respective analog signals;
switch means (4, 5) for turning on and off the respective analog signals converted by said digital-to-analog converters (2, 3) in accordance with a control signal which controls on and off of transmission of said transmission apparatus; and
filter means (6, 7) for band-restricting output signals of said switch means (4, 5).

2. A transmission apparatus for modulating a carrier signal by transmission data and transmitting the modulated carrier signal having an envelope an amplitude of which is reduced to substantially zero in accordance with predetermined change of the transmission data, said apparatus comprising:
a mapping circuit (21) for mapping the transmission data into one of predetermined signal points in the orthogonal coordinates to produce a data signal of a first channel corresponding to one coordinate axis in the orthogonal coordinates and a data signal of a second channel corresponding to the other coordinate axis;
a ramp circuit (22) for receiving the data signals of the first and second channels produced by said mapping circuit (21) to output selected one of the data signal of the first channel and a predetermined potential and output selected one of the data signal of the second channel and the predetermined potential in accordance with a control signal which controls on and off of transmission of said transmission apparatus;
digital-to-analog converters (23, 24) for converting the data signals of the first and second channels produced by said ramp circuit (22) into respective analog signals; and
filter means (25, 26) for band-restricting the respective analog signals converted by said digital-to-analog converters (23, 24).

3. A transmission apparatus according to claim 2, wherein:
said ramp circuit (22) outputs 2-bit digital data and said digital-to-analog converters (23, 24) receives the 2-bit digital data to output analog signal corresponding thereto.
